(19) **Europäisches Patentamt European Patent Office Office européen des brevets**

(11) **EP 1 063 768 B1**

(12) **EUROPÄISCHE PATENTSCHRIFT**

(45) Veröffentlichungstag und Bekanntmachung des Hinweises auf die Patenterteilung:
**29.09.2010 Patentblatt 2010/39**

(51) Int Cl.:
***H03D 3/06*** *(2006.01)*

(21) Anmeldenummer: **00111285.3**

(22) Anmeldetag: **25.05.2000**

(54) **DECT-Empfänger mit FM Demodulator**

DECT receiver with FM Demodulator

Récepteur DECT avec Démodulateur FM

(84) Benannte Vertragsstaaten:
**DE FR GB**

(30) Priorität: **22.06.1999 DE 19928546**

(43) Veröffentlichungstag der Anmeldung:
**27.12.2000 Patentblatt 2000/52**

(73) Patentinhaber: **Infineon Technologies AG**
**85579 Neubiberg (DE)**

(72) Erfinder: **LI PUMA, Guiseppe**
**44791 Bochum (DE)**

(74) Vertreter: **Viering, Jentschura & Partner**
**Postfach 22 14 43**
**80504 München (DE)**

(56) Entgegenhaltungen:
**EP-A- 0 162 525     US-A- 3 997 856**
**US-A- 4 198 609     US-A- 4 342 000**
**US-A- 4 451 792     US-A- 5 293 135**
**US-A- 5 414 385**

**Beschreibung**

Die vorliegende Erfindung betrifft einen DECT-Empfänger mit einem Koinzidenz-Demodulator für FM-modulierte Signale, ein Verfahren zur Kalibrierung eines DECT-Empfängers mit einem Koinzidenz-Demodulator für FM-modulierte Signale.

Eine Möglichkeit der FM-Demodulation ist die FM-PDM (Pulsdauermodulation)-Wandlung. Eine entsprechende Schaltungsanordnung wird als Koinzidenz-Demodulator oder auch Quadraturdemodulator bezeichnet. Eine derartige Demodulation ist beispielsweise dargestellt in Rudolf Maeusl, analoge Modulationsverfahren, Huetig Verlag, 1992.

Bei der Koinzidenz-Demodulation wird das zu demodulierende frequenzmodulierte Signal auf zwei Pfade aufgeteilt und einmal direkt und zum anderen über ein frequenzabhängiges Phasendrehglied, das bei der Trägermittenfrequenz eine Phasendrehung um 90 DEG ausführt, auf einen Mulitiplizierer (Mischer) gegeben. Nachdem die Amplitude des Modulationsprodukts direkt in das demodulierte Signal eingeht, ist eine der Demodulation vorangehende Amplitudenbegrenzung erforderlich. Durch eine starke Amplitudenbegrenzung, die zweckmässigerweise auf die beiden am Mischer anliegenden Signale wirkt, geht die Funktion des analogen Multiplizierers in die eines digitalen Multiplizierers über.

Die Linearität der FM-Demodulation wird bestimmt von der Frequenzabhängigkeit der Phasenverschiebung in dem Phasendrehglied. Einen linearen Zusammenhang erhält man mittels einer Laufzeitleitung in Form eines (idealen) Tiefpassfilters, das unterhalb seiner Grenzfrequenz betrieben wird. Weniger aufwendig ist die Ausführung eines Phasendrehglieds durch einen Schwingkreis, der in der Umgebung der Resonanzfrequenz näherungsweise linear ist. Der lineare ausnutzbare Bereich wird größer mit niedriger Kreisgüte Q.

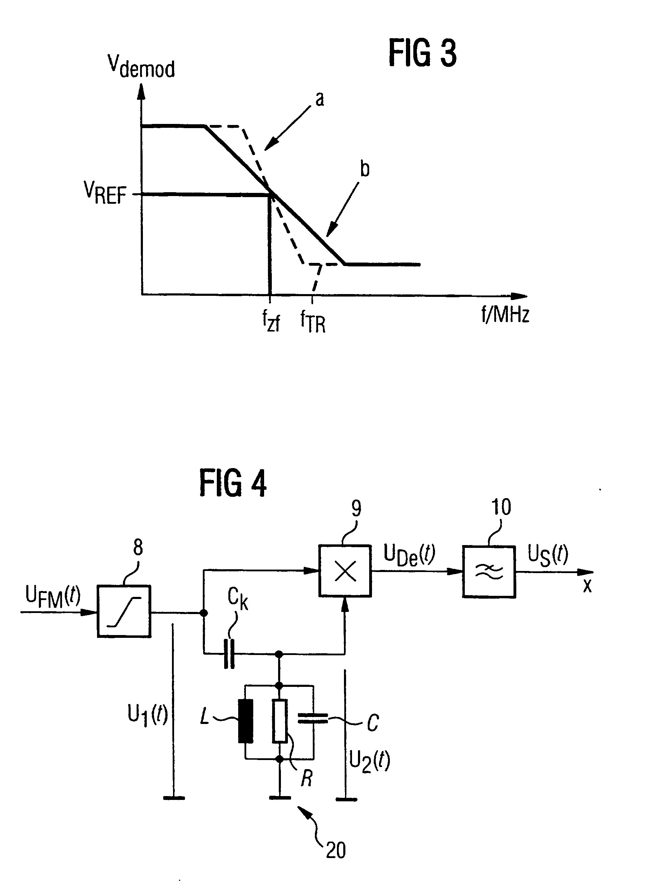

Figur 4 zeigt die Prinzipschaltung eines Koinzidenz-Demodulators mit einem Schwingkreis als Phasenschieber. Dieser in Figur 4 gezeigte Koinzidenz-Demodulator weist einen Amplitudenbegrenzer 8, einen externen Schwingkreis 20, einen Mischer 9 sowie ein Tiefpassfilter 10 am Ausgang des Mischers 9 auf. Unter der Annahme, daß den Mulitiplizierer mit u1 (t) eine auf die Amplitude begrenzte rechteckförmige Spannung zugeführt wird, deren Amplitude keinen Einfluß mehr auf die Ausgangsspannung haben soll, erhält man für die Ausgangsspannung des Multiplizierers (Mischers) 9 einen von der Amplitude und Phasenlage der Spannung $u_2(t)$ abhängigen zeitlichen Verlauf. Der nach Integration gewonnene Mittelwert ist somit abhängig von der Phasenverschiebung der beiden Spannungen $u_1(t)$ und $u_2(t)$ zueinander und damit auch abhängig von der Momentanfrequenz $f_{FM(t)}$.

Der Name "Koinzidenz-Demodulator" leitet sich ab von dem "Zusammentreffen" oder gleichzeitigem Anliegen von den gleichsinnigen positiven oder negativen Halbwellen der Spannungen $u_{1(t)}$ und $u_{2(t)}$ an die Multiplizierer, wobei das Ergebnis als Produkt der Spannungen von deren Phasenzuordnung abhängig ist. Ein anderer Name, "Quadraturdemodulator", nimmt Bezug auf die bei der Trägermittenfrequenz um 90° zueinander versetzten, also in "Quadratur" zustehenden Spannungen.

Aufgrund von Toleranzen der Bauelemente muß der Schwingkreis 20 genau auf die Trägerfrequenz des zugeführten, frequenzmodulierten Signals abgestimmt werden. Eine solche Abstimmung kann z.B. durch mechanische Justierung des Schwingkreises (einstellbarer Kondensator) oder durch Laserbearbeitung von Kondensatoren erfolgen.

In der US 4 342 000 ist ein Quadraturdemodulator gezeigt, bei dem die Phasenverschiebung zwischen den einem Mischer zuzuführenden Signalen durch ein Tiefpassfilter erzeugt wird, dessen Güte variierbar ist. Das Filter enthält zwei antiparallel geschaltete Dioden, deren Widerstand sich signalabhängig verändert. Nachteilig ist, daß eine Einstellung der Güte des Demodulators in Abhängigkeit vom Betriebszustand des Empfangsgeräts nicht erfolgen kann.

Die US 5,414,385 zeigt einen derartigen Koinzidenzdemodulator, der einen Mischer aufweist, welcher ein zu demodulierendes Signal mit einem frequenzabhängig phasenverschobenen Zweig mischt, wobei die frequenzabhängige Phasenverschiebung durch einen in seiner Güte einstellbaren Schwingkreis erfolgt.

Die vorliegende Erfindung hat es sich zur Aufgabe gemacht, eine Technik bereitzustellen, die die Kalibrierung, d.h. die Einstellung der Mittenfrequenz des Koinzidenz-Demodulators auf die Trägerfrequenz, präzisiert.

Diese Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Gemäß der vorliegenden Erfindung ist also ein DECT-Empfänger mit einem Koinzidenz-Demodulator für FM-modulierte Signale vorgesehen. Der Koinzidenz-Demodulator weist einen Mischer (Multiplizierer) auf, der ein zu demodulierendes (FM-moduliertes) Signal mit einem frequenzabhängig phasenverschobenen Zweig des zu demodulierenden Signal multipliziert. Durch einen Schwingkreis erfolgt dabei die frequenzabhängige Phasenverschiebung. Die Güte Q des Schwingkreises ist dabei einstellbar. Die Einstellung der Güte des Schwingkreises wird durch eine Steuerspannung von einem Basisbandblock gesteuert. Durch Einstellen der Güte des Schwingkreises kann somit die Kennlinie des Demodulators, genauer gesagt die Breite des Bereichs um die Mittenfrequenz des Demodulators herum, verändert werden. Bei kleinerer Güte ist die Phasensteilheit der Kennlinie in dem linearen Bereich niedriger (der Demodulator somit weniger sensitiv), aber dafür die Breite des linearen Bereichs um die Mittenfrequenz des Demodulators herum größer. Somit kann bei einem Kalibriervorgang besser gewährleistet werden, dass auch bei einem größeren Offset beispielsweise der Trägerfrequenz des Senders bezüglich der Mittenfrequenz des Demodulators sich die versetzte Trägerfrequenz im linearen Bereich des Demodulators befindet und somit gezielt ein Kalibrierungsvorgang, d.h. die Einstellung der Mittenfrequenz des Demodulators durch Veränderung der Resonanzfrequenz des Schwingkreises ausgeführt werden kann.

Die Einstellung der Güte des Schwingkreises kann durch Steuerung eines Widerstandswerts eines Widerstands des Schwingkreises erfolgen.

Die Einstellung der Güte des Schwingkreises kann durch Ein/Ausschalten eines Transistors erfolgen, der parallel zu einem Kondensator und einer Induktivität des Schwingkreises geschaltet ist.

Die Einstellung der Güte des Schwingkreises kann durch Ein/Ausschalten wenigstens eines Transistors erfolgen, der gegen Masse geschaltet ist.

Der steuerbare Widerstand zusammen mit dem Mischer auf einem Chip als Baustein integriert werden.

Gemäß der vorliegenden Erfindung ist weiterhin ein Verfahren zur Kalibrierung eines DECT-Empfängers, der einen Koinzidenz-Demodulator für FM-modulierte Signale aufweist, vorgesehen. Die Kalibrierung erfolgt durch Justierung der Mittenfrequenz des Koinzidenz-Demodulators zur Verringerung einer OffsetSpannung am Ausgang des Koinzidenz-Demodulators. Dabei wird während der Kalibrierung die Güte des Schwingkreises verringert, um die Breite des Linearbereichs des Demodulators zu vergrößern.

Die Verringerung der Güte des Schwingkreises kann durch Schalten eines Transistors in seinem leitfähigen Zustand erfolgen, wobei der Transistor parallel zu einem Kondensator und einer Induktivität des Schwingkreises geschaltet ist.

Die Verringerung der Güte des Schwingkreises kann auch durch Schalten wenigstens eines Transistors erfolgen, wobei der Transistor gegen Masse geschaltet ist.

Die Kalibrierung kann insbesondere während eines Zeitschlitzes in einem Zeitmultiplex-System (beispielsweise dem DECT-Standard) erfolgen, während dem keine modulierten Daten übertragen werden. Derartige Zeitschlitze werden auch "blind slots" genannt.

Die Erfindung betrifft die Anwendung des oben genannten Verfahrens auf die Kalibrierung eines DECT-Empfängers mit einem Koinzidenz-Demodulator für eine Übertragung gemäß dem DECT-Standard.

Weitere Vorteile, Merkmale und Eigenschaften der vorliegenden Erfindung werden aus der folgenden Beschreibung von Ausführungsbeispielen und bezugnehmend auf die begleitenden Figuren der Zeichnungen näher ersichtlich.

Fig. 1 zeigt einen Empfängerzweig mit einem Koinzidenz-Demodulator,
Fig. 2a zeigt einen Koinzidenz-Demodulator eines DECT-Empfängers gemäß der vorliegenden Erfindung,
Fig. 2b zeigt einen Ausschnitt von Fig. 2a gemäß einem weiteren Ausführungsbeispiel der Erfindung, Fig. 3 zeigt die einstellbare Kennlinie eines Koinzidenz-Demodulators eines erfindungsgemäßen DECT-Empfängers, und Fig. 4 zeigt eine allgemeine aus dem Stand der Technik bekannte Darstellung eines Koinzidenz-Demodulators.

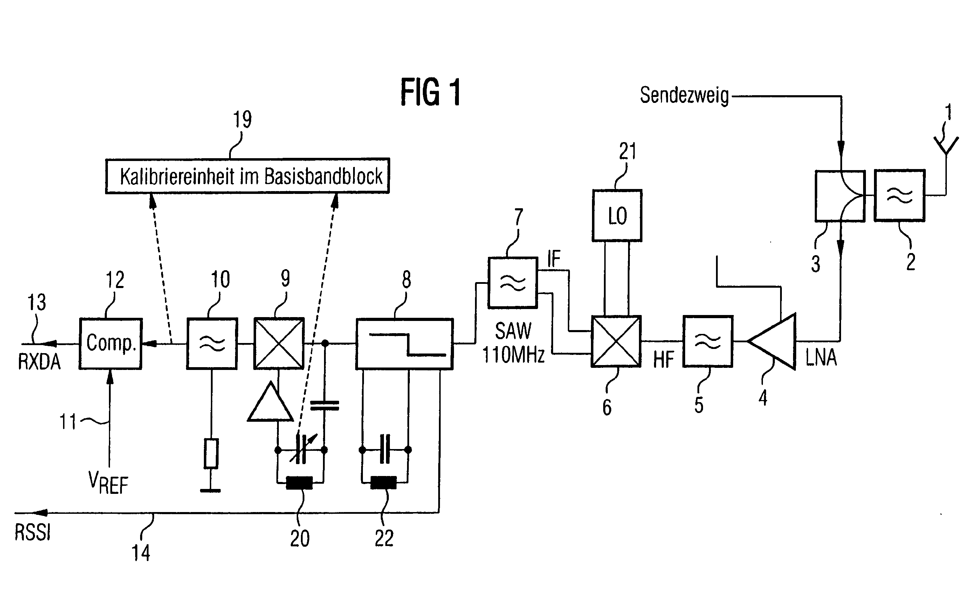

Bezugnehmend auf Fig. 1 soll zuerst ein Empfängerzweig beispielsweise eines DECT-Bausteins beschrieben werden. Ein Signal, das von einer Antenne 1 empfangen wird, wird durch ein Filter 2 zu einer Sende/ Empfangsweiche 3 gegeben. Das Signal wird nach einer Verstärkung 4 und einer weiteren Filterung 5 als Hochfrequenzsignal zu einem Mischer 6, der das empfangene Signal mit dem Signal von einem Lokaloszilator 21 auf eine Zwischenfrequenz IF heruntersetzt. Nach einer weiteren Filterung 7 wird das Zwischenfrequenzsignal IF einem Amplitudenbegrenzer 8 zugeführt. Der externe, parallel zu dem Amplitudenbegrenzer 8 geschaltete Resonanzkreis 22 unterdrückt Breitbandrauschen, um die Sensitivität des Empfängers zu verbessern. An dem Amplitudenbegrenzer 8 kann darüber hinaus ein RSSI (radio signal strength indicator)-Signal 14 abgenommen werden.

Das amplitudenbegrenzte Signal von dem Amplitudenbegrenzer 8 wird schließlich dem Koinzidenz-Demodulator 9 zugeführt. Das Ausgangssignal des Koinzidenz-Demodulators 9 wird gefiltert 10 und dann einem Komparator 12 zugeführt, der es mit einer Referenzspannung 11 vergleicht. Der Komparator 12 schaltet somit zwischen zwei Zuständen hin- und her und gibt dieses digitalisierte Ausgangssignal, daß die demodulierte Information darstellt, zu einem Basisbandblock 13. Der Basisbandblock 13 ist dem Demodulator also nachgeschaltet.

Während einer Kalibrierung, d.h. einer Einstellung der Mittenfrequenz des Koinzidenz-Demodulators 9 auf die tatsächliche Trägerfrequenz, die von einem Sender verwendet wird, wird dem Koinzidenz-Demodulator 9 ein unmoduliertes, d.h. ein nicht FM-moduliertes Signal zugeführt. In diesem Zustand sollte das Ausgangssignal des Koinzidenz-Demodulators nach der Integration 10 möglichst 0 betragen. Eine Kalibriereinheit 19 im Basisbandblock 13 erfaßt das integrierte Ausgangssignal des Koinzidenz-Demodulators 9 und verändert dann die Resonanzfrequenz des Schwingkreises 20 derart, daß das integrierte Ausgangssignal auf 0 gezogen wird. Die Änderung der Resonanzfrequenz des Schwingkreises 20 kann beispielsweise durch Einstellen eines Kondensators wie in Figur 1 angedeutet oder aber auch durch Laserbearbeitung einer Kapazität erfolgen (einmalig nach der Fertigung des Koinzidenz-Demodulators 9.

Wie bereits gesagt, kann die Trägerfrequenz eines Senders bezüglich der Mittenfrequenz des Koinzidenz-Demodulators 9 einen Offset aufweisen, wie es in Figur 3 gezeigt ist. Die Mittenfrequenz $f_{ZF}$ ist dabei die Frequenz, bei der das Ausgangssignal der Referenzspannung $V_{REF}$ entspricht. Wenn nunmehr das die Trägerfrequenz des den Koinzidenz-Demodulators 9 eingegebenen HF-Signals gleich $f_{TR}$ ist, wie in Figur 3 gezeigt ist, kann wie dargestellt der Fall auftreten, daß dieser Offset so groß ist, daß die Trägerfrequenz $f_{TR}$ außerhalb des Linearitätsbereichs des Koinzidenz-Demodulators 9 ist auch für den Fall der Kennlinie a.

Außerhalb des Linearitätsbereichs ist indessen der Kalibriervorgang kaum möglich, da ja eine Verschiebung der Mittenfrequenz des Koinzidenz-Demodulators 9 um einen gewissen Differenzwert für diesen genannten Fall keine Änderung der Ausgangsspannung bewirkt.

Erfindungsgemäß wird daher bei der Kalibrierung die Kennlinie des Koinzidenz-Demodulators 9 derart geändert, daß der Linearitätsbereich des Koinzidenz-Demodulators 9 vergrößert wird. Das kann wie in Figur 3 dargestellt durch Umschalten auf eine "flachere" Kennlinie b erfolgen. Zur Veränderung der Demodulatorkennlinie wird gemäß der Erfindung die Güte Q des Schwingkreises 20 verringert. Dabei gilt folgender Zusammenhang:

$$S= -\frac{2*Q}{f_0},$$

wobei S die Phasensteilheit der Übertragungskennlinie, $f_0$ die Resonanzfrequenz des Schwingkreises (im wesentlichen gleich der Zwischenfrequenz $f_{ZF}$ des Koinzidenz-Demodulators) und Q die Güte des Schwingkreises ist.

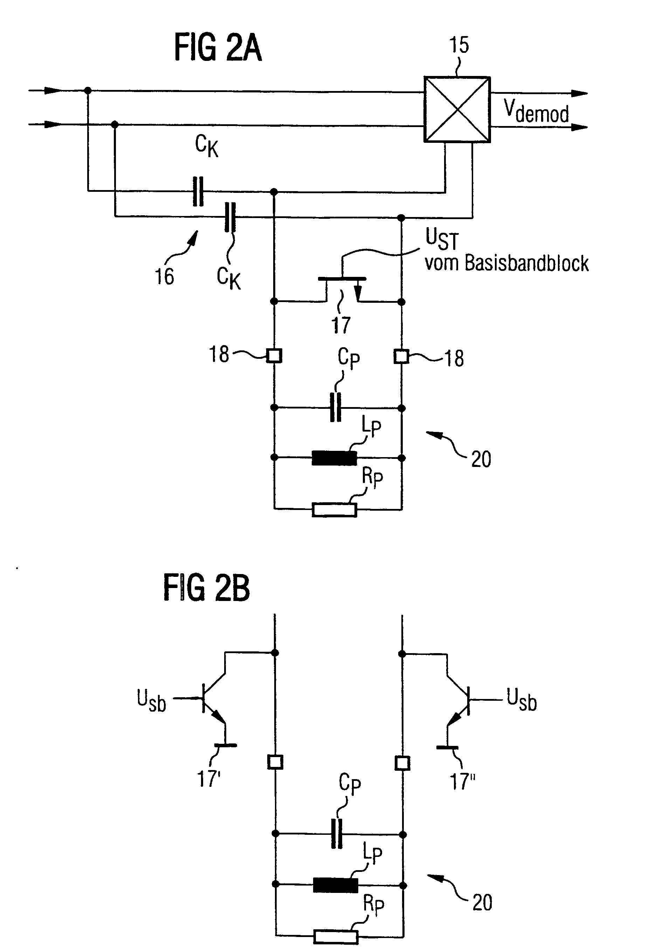

Figur 2a zeigt ein Ausführungsbeispiel zur gesteuerten Veränderung, d.h. zur Einstellung der Güte Q des Schwingkreises 20. Der Schwingkreis weist dabei einen Kondensator $C_P$, eine Induktivität $L_P$ und ein Widerstand $R_P$ auf. Dieser eigentliche Schwingkreis 20 befindet sich bei der Implementierung außerhalb eines integrierten Chips und ist über Anschlußpins 18 mit dem Chip verbunden, auf dem beispielsweise der Mischer 15 integriert ist.

Zur Veränderung der Güte Q des Schwingkreises 20 ist ein MOS-Transistor 17 vorgesehen, dessen Steuerspannung beispielsweise vom Basisbandblock 13 zugeführt wird. Durch Ein-und Ausschalten des MOS-Transistors kann somit die Güte Q des Schwingkreises verändert werden.

Figur 2b zeigt ein Detail von Figur 2a gemäß einem weiteren Ausführungsbeispiel der Erfindung. Gemäß diesem Ausführungsbeispiel ist wenigstens ein bspw. vom Basisbandblock 13 angesteuerter Transistor 17', 17" gegen Masse geschaltet. Im dargestellten Beispiel sind zwei gegen Masse geschaltete Transistoren 17', 17" gezeigt, die jeweils zur Änderung der Güte Q des Schwingkreises 20 geschaltet werden. Alternativ kann auch nur ein geschalteter Transistor vorgesehen sein, der gegen Masse geschaltet ist.

Bezugnehmend nochmals auf Figur 3 wird beispielsweise die Kennlinie a für den Fall erhalten, daß der MOS-Transistor 17 ausgeschaltet ist, und die Kennlinie b, falls der MOS-Transistor 17 eingeschaltet ist. Allgemein wird also die Güte Q des Schwingkreises 20 durch Veränderung eines Widerstandswerts verändert.

Der Kalibrierungsvorgang kann vorteilhafterweise für den Fall von Übertragung in Systemen mit Zeitschlitzen (wie es beispielsweise bei dem DECT-Standard der Fall ist) während der sogenannten "blind slots" erfolgen, während der keine FM-modulierte Information übertragen wird. Der Basisbandblock 13, dem die zeitliche Lage der "blind slots" bekannt ist, kann somit vorteilhafterweise auch das die Veränderung der Kennlinie des Koinzidenz-Demodulators zur Ausführung der Kalibrierung während der "blind slots" durchführen.

Bezugszeichenliste

1. Antenne
2. Sende/Empfangs-Filter
3. Sende/Empfangs-Weiche
4. LNA-Verstärker
5. HF-Filter
6. Mischer
7. IF-Filter
8. Amplitudenbegrenzer
9. Koinzidenz-Demodulator
10. Filter
11. Referenzspannung
12. Komparator
13. Basisbandblock
14. RSSI-Signal
15. Multiplizierer
16. Koppelkondensator
17. MOS-Transistor
17'. Transistor gegen Masse (geschaltet)
17''. Transistor gegen Masse (geschaltet)
18. Pin
19. Kalibriereinheit
20. Schwingkreis
21. Lokaloszilator
22. Schwingkreis des Amplitudenbegrenzers

**Patentansprüche**

1. DECT-Empfänger,
   **dadurch gekennzeichnet,**
   **dass** er einen Koinzidenz-Demodulator für FM-modulierte Signale aufweist,
   der Koinzidenz-Demodulator aufweisend einen Mischer (15), der ein zu demodulierendes Signal mit einem frequenzabhängig phasenverschobenen Zweig des zu demodulierenden Signals mischt, wobei die frequenzabhängige Phasenverschiebung durch einen Schwingkreis (20) erfolgt, dessen Güte einstellbar ist, und wobei

die Einstellung der Güte des Schwingkreises (20) von einem dem Demodulator nachgeschalteten Basisbandblock (13) gesteuert wird.

2. DECT-Empfänger nach Anspruch 1,
**dadurch gekennzeichnet,**
**dass** die Einstellung der Güte des Schwingkreises (20) durch Steuerung eines Widerstandswerts eines Widerstands (17, Rp) des Schwingkreises (20) erfolgt.

3. DECT-Empfänger nach Anspruch 1 oder 2,
**dadurch gekennzeichnet,**
**dass** die Einstellung der Güte des Schwingkreises (20) durch Ein-/Ausschalten eines Transistors (17) erfolgt, der parallel zu einem Kondensator (Cp) und einer Induktivität (Lp) geschaltet ist.

4. DECT-Empfänger nach Anspruch 1 oder 2,
**dadurch gekennzeichnet,**
**dass** die Einstellung der Güte des Schwingkreises (20) durch Ein-/Ausschalten wenigstens eines Transistors (17', 17") erfolgt, der gegen Masse geschaltet ist.

5. DECT-Empfänger nach Anspruch 2,
**dadurch gekennzeichnet,**
**dass** der steuerbare Widerstand (17) zusammen mit dem Mischer (15) auf einem Chip integriert ist.

6. Verfahren zur Kalibrierung eines DECT-Empfängers, der einen Koinzidenz-Demodulator für FM-modulierte Signale aufweist, wobei der Koinzidenz-Demodulator einen Mischer (15) aufweist, der ein zu demodulierendes Signal mit einem frequenzabhängig phasenverschobenen Zweig des zu demodulierenden Signals mischt, wobei die frequenzabhängige Phasenverschiebung durch einen Schwingkreis (20) erfolgt, dessen Güte einstellbar ist,
**dadurch gekennzeichnet, dass**
die Kalibrierung durch Justierung der Mittenfrequenz des Koinzidenz-Demodulators (9) zur Verringerung einer OffsetSpannung am Ausgang des Koinzidenz-Demodulators (9) erfolgt, und vor der Kalibrierung eine Güte des Schwingkreis (20) verringert wird.

7. Verfahren nach Anspruch 6,
**dadurch gekennzeichnet,**
**dass** die Verringerung der Güte des Schwingkreises (20) durch Veränderung eines Widerstandswerts eines Widerstands (17, Rp) des Schwingkreises (20) erfolgt.

8. Verfahren nach Anspruch 6 oder 7,
**dadurch gekennzeichnet,**
**dass** die Verringerung der Güte des Schwingkreises (20) durch Schalten eines Transistors (17) in seinen leitfähigen Zustand erfolgt, wobei der Transistor (17) parallel zu einem Kondensator (Cp) und einer Induktivität (Lp) geschaltet ist.

9. Verfahren nach Anspruch 6 oder 7,
**dadurch gekennzeichnet,**
**dass** die Verringerung der Güte des Schwingkreises (20) durch Schalten wenigstens eines Transistors (17', 17") erfolgt, der gegen Masse geschaltet ist.

10. Verfahren nach einem der Ansprüche 6 bis 9,
**dadurch gekennzeichnet,**
**dass** die Kalibrierung während eines Zeitschlitzes in einem Zeitmultiplex-System erfolgt, während dem keine modulierten Daten übertragen werden.

**Claims**

1. DECT-receiver,
**characterized in that**
it comprises a coincidence demodulator for FM-modulated signals,
the coincidence demodulator comprising a mixer (15), which mixes a signal to be demodulated with a frequency dependent phase-shifted branch of the signal to be demodulated, wherein
the frequency dependent phase shift takes place by a resonant circuit (20), the quality of which is adjustable, and wherein
the adjustment of the quality of the resonant circuit (20) is controlled by a base band block (13) downstream connected to the demodulator.

2. DECT-receiver according to claim 1,
**characterized in that**
the adjustment of the quality of the resonant circuit (20) takes place by controlling the resistance value of a resistor (17, Rp) of the resonant circuit (20).

3. DECT-receiver according to claim 1 or 2,
**characterized in that**
the adjustment of the quality of the resonant circuit (20) takes place by switching on/out a transistor (17), which is connected in parallel to a capacity (Cp) and an inductivity (Lp).

4. DECT-receiver according to claim 1 or 2,
**characterized in that**
the adjustment of the quality of the resonant circuit (20) takes place by switching on/out at least one transistor (17', 17"), which is switched against ground.

5. DECT-receiver according to claim 2,

**characterized in that**
the controllable resistor (17) is integrated with the mixer (15) on a chip.

6.  Method for calibration of a DECT-receiver, which comprises a coincidence demodulator for FM-modulated signals,
    wherein the coincidence demodulator comprises a mixer (15), which mixes a signal to be demodulated with a frequency dependent phase-shifted branch of the signal to be demodulated,
    wherein the frequency dependent phase shift takes place by a resonant circuit (20), the quality of which is adjustable,
    **characterized in that**
    the calibration takes place by adjusting the center frequency of the coincidence demodulator (9) for reducing an offset voltage at the output of the coincidence demodulator (9) and a quality of the resonant circuit (20) is reduced before the calibration.

7.  Method according to claim 6,
    **characterized in that**
    the reduction of the quality of the resonant circuit (20) takes place by changing a resistance value of a resistor (17, Rp) of the resonant circuit (20).

8.  Method according to claim 6 or 7,
    **characterized in that**
    the reduction of the quality of the resonant circuit (20) takes place by switching a transistor (17) to its conductive state, wherein the transistor (17) is connected in parallel to a capacity (Cp) and an inductivity (Lp).

9.  Method according to claim 6 or 7,
    **characterized in that**
    the reduction of the quality of the resonant circuit (20) takes place by switching at least one transistor (17', 17"), which is connected against ground.

10. Method according to one of the claims 6 to 9,
    **characterized in that**
    the calibration during a time slot takes place in a time multiplex system, during which no modulated data are transmitted.


**Revendications**

1.  Récepteur DECT,
    **caractérisé**
    **en ce qu'**il comporte un démodulateur de coïncidence, pour des signaux modulés FM,
    le démodulateur de coïncidence comprenant un mélangeur (15), qui mélange un signal à démoduler à une branche, déphasée en fonction de la fréquence, du signal démodulé, le déphasage, en fonction de la fréquence, s'effectuant par un circuit (20) oscillant de qualité réglable,
et dans lequel
le réglage de la qualité du circuit (20) oscillant est commandé par un bloc (13) de bande de base monté en aval du démodulateur.

2.  Récepteur DECT suivant la revendication 1,
    **caractérisé**
    **en ce que** le réglage de la qualité du circuit (20) oscillant s'effectue en commandant une valeur d'une résistance (17, Rp) du circuit (20) oscillant.

3.  Récepteur DECT suivant la revendication 1 ou 2,
    **caractérisé**
    **en ce que** le réglage de la qualité du circuit (20) oscillant s'effectue en mettant, à l'état passant/à l'état bloqué, un transistor (17) qui est monté en parallèle à un condensateur (Cp) et à une inductance (Lp).

4.  Récepteur DECT suivant la revendication 1 ou 2,
    **caractérisé**
    **en ce que** le réglage de la qualité du circuit (20) oscillant s'effectue en mettant à l'état bloqué/à l'état passant, au moins un transistor (17', 17") qui est monté par rapport à la masse.

5.  Récepteur DECT suivant la revendication 2,
    **caractérisé**
    **en ce que** la résistance (17) qui peut être commandée, est intégrée ensemble avec le mélangeur (15) sur une puce.

6.  Procédé d'étalonnage d'un récepteur DECT, qui comporte un démodulateur de coïncidence, pour des signaux modulés FM,
    dans lequel le démodulateur de coïncidence comporte un mélangeur (15) qui mélange un signal à démoduler à une branche, déphasée en fonction de la fréquence, du signal démodulé, le déphasage, en fonction de la fréquence, s'effectuant par un circuit (20) oscillant de qualité réglable,
    **caractérisé en ce que**
    on effectue l'étalonnage en réglant la fréquence médiane du démodulateur (9) de coïncidence, pour diminuer une tension de décalage à la sortie du démodulateur (9) de coïncidence et on diminue une qualité du circuit (20) oscillant avant l'étalonnage.

7.  Procédé suivant la revendication 6,
    **caractérisé en ce que**
    on effectue la diminution de la qualité du circuit (20) oscillant, en modifiant une valeur d'une résistance (17, Rp) du circuit (20) oscillant.

8.  Procédé suivant la revendication 6 ou 7,
    **caractérisé en ce que**

on effectue la diminution de la qualité du circuit (20) oscillant, en mettant un transistor (17) à son état passant, le transistor (17) étant monté en parallèle à un condensateur (Cp) et à une inductance (Lp).

9. Procédé suivant la revendication 6 ou 7, **caractérisé en ce que** l'on effectue la diminution de la qualité du circuit (20) oscillant, en montant au moins un transistor (17', 17"), qui est monté par rapport à la masse.

10. Procédé suivant l'une des revendications 6 à 9, **caractérisé en ce que** l'on effectue l'étalonnage pendant un créneau temporel, dans un système de multiplexage temporel, pendant lequel des données modulées ne sont pas transmises.

FIG 1

## FIG 2A

## FIG 2B

# FIG 3

# FIG 4

## IN DER BESCHREIBUNG AUFGEFÜHRTE DOKUMENTE

### In der Beschreibung aufgeführte Patentdokumente

- US 4342000 A
- US 5414385 A

### In der Beschreibung aufgeführte Nicht-Patentliteratur

- **Rudolf Maeusl.** analoge Modulationsverfahren. Huetig Verlag, 1992